# EUROPÄISCHE PATENTSCHRIFT

(11) **EP 3 656 056 B1**
(45) Veröffentlichungstag und Bekanntmachung des Hinweises auf die Patenterteilung: **08.09.2021**
(21) Anmeldenummer: 18756368.9
(22) Anmeldetag: 16.07.2018
(51) Int. Cl.: H03K 3/42

(54) **FOLGE-HALTE-SCHALTUNG**
SAMPLE AND HOLD CIRCUIT
CIRCUIT D'ÉCHANTILLONNAGE ET DE MAINTIEN

(30) Priorität: 17.07.2017 DE 102017116001
(43) Veröffentlichungstag der Anmeldung: 27.05.2020
(73) Patentinhaber: Universität Paderborn, 33098 Paderborn (DE)
(72) Erfinder: SCHEYTT, Johann Christoph, 46284 Dorsten (DE)
(74) Vertreter: Ostermann, Thomas
(86) Internationale Anmeldenummer: PCT/DE2018/100650
(87) Internationale Veröffentlichungsnummer: WO 2019/015724

(56) Entgegenhaltungen:
- EP-A1- 2 660 821
- EP-A2- 2 819 309
- US-A1- 2008 150 590

## Beschreibung

Die Erfindung betrifft eine Folge-Halte-Schaltung nach dem Oberbegriff des Patentanspruchs 1.

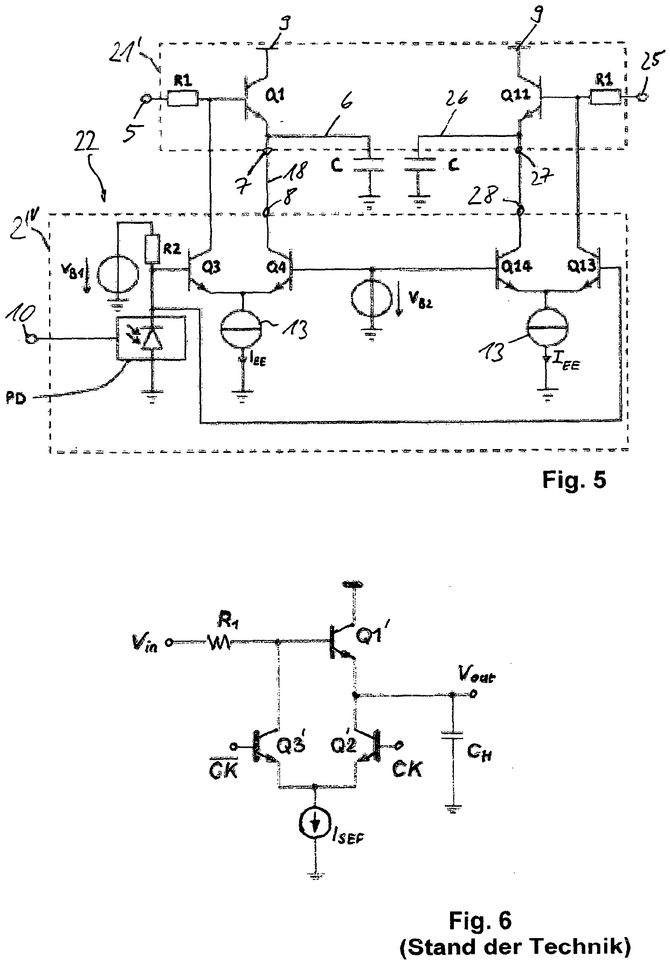

Aus der US 7 696 792 B2 ist eine Folge-Halte-Schaltung zum Konvertieren eines analogen Eingangssignals in ein digitales Ausgangssignal bekannt, das eine Haltekapazitätseinheit, eine Spannungsverstärkereinheit und eine Arbeitspunkteinstelleinheit aufweist. Die Spannungsverstärkereinheit umfasst eine Emitterfolgeschaltung, die emitterseitig mit einer Stromquelle verbunden ist. Als Arbeitspunkteinstelleinheit für die Spannungsverstärkereinheit ist eine Schalteinheit vorgesehen, die periodische Taktsignale einer Taktsignaleinheit erzeugt und als Steuersignale an den Eingang der Spannungsverstärkereinheit abgibt. Ist das Steuersignal als ein hohes Taktsignal ausgebildet, ist die Haltekapazitätseinheit mit dem Eingangsspannungssignal verbunden, so dass die Spannung der Haltekapazitätseinheit der Eingangsspannung folgt (Folgebetrieb). Ist das Steuersignal als ein tiefes Taktsignal ausgebildet, entspricht das Ausgangssignal der Halte-Folge-Schaltung der Spannung der Haltekapazitätseinheit (Haltebetrieb). Nachteilig an der bekannten Folge-Halte-Schaltung ist die begrenzte Bandbreite und Schaltzeit. Da die Folge-Halte-Schaltung als Bestandteil eines Analog-Digital-Wandlers die effektive Auflösung, Linearität und Bandbreite desselben bestimmt, ist es wünschenswert, die genannten Parameter weiter zu verbessern. Eine in Figur 6 dargestellte bekannte Folge-Halte-Schaltung weist neben einer Haltekapazitätseinheit und einer Spannungsverstärkereinheit eine Arbeitspunkteinstelleinheit mit im Gegentakt betriebenen Transistoren Q2' und Q3' auf. Die Spannungsverstärkereinheit wird durch einen Emitterfolger Q1' gebildet. Ein Emitteranschluss dieses Emitterfolgers Q1' bildet die Ausgangsspannung der Spannungsverstärkereinheit, an der eine Kapazität C_{H} der Haltekapazitätseinheit anliegt. Liegt an der Basis des Transistors Q2' ein hohes Taktsignal an, während an der Basis des Transistors Q3' ein niedriges Taktsignal anliegt, schaltet der Emitterfolger Q1' durch, so dass sich die Folge-Halte-Schaltung in dem Folgebetrieb befindet. Liegt an dem Transistor Q2' ein niedriges Taktsignal und an dem Transistor Q3' ein hohes Taktsignal an, führt das zum Sperren des Emitterfolgers Q1', so dass sich die Folge-Halte-Schaltung in dem Haltebetrieb befindet, in dem die Ausgangsspannung konstant ist und damit der Kondensatorspannung C_{H} entspricht. Nachteilig an dieser Folge-Halte-Schaltung ist, dass die effektive Auflösung, Linearität und Bandbreite begrenzt sind. Die effektive Auflösung wird insbesondere durch den Jitter und die Flankensteilheit des Taktsignals bestimmt.

Aus der EP 2 660 821 A1 ist eine Folge-Halte-Schaltung zum Konvertieren eines analogen Eingangssignals in ein Ausgangs-Abtastsignal bekannt, die eine Haltekapazitätseinheit, eine Spannungsverstärkereinheit sowie eine Haltekapazitätseinheit aufweist. Die Arbeitspunkteinstelleinheit weist eine Laserdiode als elektrooptisches Mittel zur Erzeugung eines Steuersignals auf, so dass als Taktsignal eine optische Impulsfolge mit hohen und tiefen Taktsignalen an einen Eingang der Arbeitspunkteinstelleinheit anliegt. Die Arbeitspunkteinstelleinheit wird mit dem Taktsignal so gesteuert, dass sich die Spannungsverstärkereinheit entweder im Halte- oder im Folgebetrieb befindet.

Aufgabe der vorliegenden Erfindung ist es daher, eine Folge-Halte-Schaltung zum Konvertieren eines analogen Eingangssignals in ein digitales Ausgangssignal derart weiterzubilden, dass die elektrischen Eigenschaften, insbesondere hinsichtlich Genauigkeit, Bandbreite, Taktjitter und Auflösung verbessert werden.

Zur Lösung dieser Aufgabe weist die Erfindung die Merkmale des Patentanspruchs 1 auf.

Nach der Erfindung ist eine Arbeitspunkteinstelleinheit für eine Spannungsverstärkereinheit eingangsseitig mit einer optischen Taktsignalquelle gekoppelt, so dass optische Taktsignale an dem Eingang der Arbeitspunkteinstelleinheit anliegen. Die Taktung bzw. Ansteuerung der Spannungsverstärkereinheit erfolgt somit auf Basis eines optischen Signals, was eine verkürzte Schaltzeit der Folge-Halte-Schaltung bewirkt. Durch die eingeprägte optische Impulsfolge lässt sich eine vergleichsweise hohe Flankensteilheit erzielen. Vorteilhaft ermöglicht die Erfindung darüber hinaus einen relativ geringen Jitter in einer Abtast- bzw. Folgephase der Folge-Halte-Schaltung. Die Spannungsverstärkereinheit ist vorzugsweise als eine lineare Spannungsverstärkereinheit mit geringer Spannungsverstärkung (z.B. nahe 1) ausgebildet, so dass gleichzeitig eine hohe Bandbreite, ein niedriger Taktjitter, eine kleine Schaltzeit und eine gute Linearität erreicht werden können.

Nach einer Variante der Erfindung weist die Arbeitspunkteinstelleinheit eine Sperrspannungskonstantschaltung auf, mittels derer die Fotodiode im Folgebetrieb bei einer konstanten Sperrspannung betreibbar ist. Vorteilhaft kann hierdurch eine genaue Abtastung erzielt werden, da am Steuereingang der Spannungsverstärkereinheit die Pulsform eines Stromes anliegt, die immer gleich und unabhängig von dem Eingangssignal der Folge-Halte-Schaltung ist. Eine Rückwirkung der Eingangsspannung oder der Steuerspannung der Spannungsverstärkereinheit auf die Sperrspannung der Fotodiode wird verhindert. Vorteilhaft wird die Sperrspannung der Fotodiode konstant gehalten bzw. auf einem relativ hohen Niveau konstant gehalten. Vorteilhaft kann hierdurch die Bandbreite der Fotodiode maximiert werden. Die Sperrspannungskonstantschaltung weist einen Transistor in Basisschaltung auf, an dessen Basis eine vorgegebene konstante Arbeitspunktspannung anliegt, dessen Emitter mit der Fotodiode und dessen Kollektor mit der Spannungsverstärkereinheit verbunden ist. Durch die konstante Arbeitspunktspannung ist die Pulsform des Stromes am Steuerausgang der Arbeitspunkteinstelleinheit immer gleich und unabhängig von der Eingangsspannung der Spannungsverstärkereinheit. Nach einer Variante der Erfindung weist die Arbeitspunkteinstelleinheit eine Basis-Emitterspannungs-Begrenzungsschaltung zur Begrenzung der Basisemitterspannung der Spannungsverstärkereinheit im Haltebetrieb auf. Hierbei fließt im Haltebetrieb ein Ausgleichsstrom quasi parallel zu dem Emitterfolger von der Basis desselben zum Masseanschluss. Hierdurch wird die Spannung an der Basis des Emitterfolgers reduziert und somit auch die Basis-Emitterspannung desselben. Die Eingangsspannung der Spannungsverstärkereinheit erhält dadurch eine höhere Variationsbreite im Haltebetrieb, ohne dass die Spannungsverstärkereinheit durch das Eingangssignal in den Folgebetrieb gebracht wird.

Nach einer bevorzugten Ausführungsform der Erfindung weist die Spannungsverstärkereinheit eine Emitterfolgeschaltung auf. Die Arbeitspunkteinstelleinheit weist eine in Sperrrichtung betriebene Fotodiode auf, die bei Anliegen des optischen hohen Taktsignals einen Steuerstrom erzeugt für den Folgebetrieb und bei Anliegen eines optischen tiefen Taktsignals keinen Steuerstrom erzeugt für den Haltebetrieb. Die Emitterfolgeschaltung ermöglicht eine relativ hohe Bandbreite sowie gute Linearität.

Nach einer Weiterbildung der Erfindung weist die Basis-Emitter-Spannungsbegrenzungsschaltung eine Stromquelle und zwei mit derselben verbundene Transistoren auf, wobei der erste Transistor direkt mit dem Basisanschluss des Emitterfolgers und der zweite Transistor mit dem Emitteranschluss der Emitterfolgeschaltung verbunden ist. Während an der Basis des ersten Transistors ein Widerstand (Reihenwiderstand) in Reihe mit einer konstanten Arbeitspunktspannungsquelle anliegt und zusätzlich an der Basis des ersten Transistors eine in Sperrrichtung betriebene Fotodiode angeschlossen ist, liegt an dem zweiten Transistor die konstante Vergleichsspannungsquelle an. Die Vergleichsspannungsquelle ist so gewählt, dass im Haltebetrieb, d.h. wenn ein niedriges optisches Taktsignal anliegt und somit kein Photostrom in der Photodiode erzeugt wird und somit auch keine Spannung am Reihenwiderstand abfällt, die Basis des ersten Transistors auf einer höheren Spannung liegt als die Vergleichsspannung, die an der Basis des zweiten Transistors an liegt. In diesem Fall fließt der Strom nur durch den ersten Transistor und der zweite Transistor ist hochohmig . Gleichzeitig werden Vergleichsspannung, optische Leistung des optischen Taktsignals und der Reihenwiderstand so gewählt, dass im Folgebetrieb, d.h. wenn ein hohes optisches Taktsignal anliegt und somit ein Photostrom in der Photodiode erzeugt wird und eine Spannung am Widerstand R2 abfällt, dass die Basisspannung des ersten Transistors auf einer niedrigeren Spannung als die Vergleichsspannung an der Basis des zweiten Transistors liegt. In diesem Fall fließt der Strom nur durch den zweiten Transistor und der erste Transistor ist hochohmig.

Nach einer Weiterbildung der Erfindung ist die Spannungsverstärkereinheit als eine Gegentakt-Spannungsverstärkerschaltung ausgebildet mit zwei gleichen jeweils an dem gleichen Versorgungspotenzial angeschlossenen Emitterfolgeschaltungen mit zwei Gegentakteingängen und mit zwei Gegentaktausgängen, an denen jeweils eine Haltekapazität der Haltekapazitätseinheit angeschlossen sind, wobei die Emitterfolgerschaltungen durch die Steuerung der Arbeitspunkteinstelleinheit jeweils gemeinsam im Folgebetrieb oder gemeinsam im Haltebetrieb arbeiten.. Entsprechend weist die Arbeitspunkteinstelleinheit zwei Transistoren mit Basisschaltung auf, die als Sperrspannungskonstantschaltung arbeiten, die jeweils basisseitig mit derselben konstanten Arbeitspunktspannungsquelle verbunden sind und emitterseitig mit derselben Fotodiode verbunden sind. Die Kollektoranschlüsse der Transistoren der Arbeitspunkteinstelleinheit bilden die Steuereingänge für die Spannungsverstärkereinheit. Vorteilhaft ist, dass die Gegentaktspannung an den Ausgängen der Spannungsverstärkereinheit nicht abhängig von den Gleichtaktspannungen der Folge-Halte-Schaitung, nämlich insbesondere der Gleichtakteingangsspannung der Spannungsverstärkereinheit sind. Vorteilhaft ermöglicht die Schaltung einen kleinen Jitter des Abtasttakts, eine schnelle Schaltzeit, eine Linearität der Abtastung, eine hohe Bandbreite sowie eine genaue Einstellung der Sperrspannung der Fotodiode unabhängig von den Eingangssignalen der Spannungsverstärkereinheit, sowie eine Unabhängigkeit des Gegentaktausgangssignals von dem Gleichtakteingangssignal der Folge-Halte-Schaltung. Weitere Vorteile der Erfindung ergeben sich aus den weiteren Unteransprüchen.

Ausführungsbeispiele der Erfindung werden nachfolgend anhand der Zeichnungen näher erläutert.

Es zeigen:
- Fig. 1: eine Folge-Halte-Schaltung nach einer ersten Ausführungsform,
- Fig. 2: eine Folge-Haite-Schaltung nach einer zweiten Ausführungsform,
- Fig. 3: eine Folge-Halte-Schaltung nach einer dritten Ausführungsform,
- Fig. 4: eine Folge-Halte-Schaltung nach einer vierten Ausführungsform,
- Fig. 5: eine Folge-Halte-Schaltung nach einer fünften Ausführungsform und
- Fig. 6: eine Folge-Halte-Schaltung nach dem Stand der Technik.

Eine erfindungsgemäße Folge-Halte-Schaltung ist vorzugsweise in einem Anaiog-Digital-Wandier integriert. Diese Wandler können beispielsweise in der Kommunikationstechnik, Sensortechnik, Regelungstechnik und dergleichen eingesetzt werden. Die Folge-Halte-Schaltung dient hierbei als Eingangsschaltung des Analog-Digital-Wandlers, bei dem ein analoges Eingangssignal abgetastet und der analoge Signalwert so lange auf einen konstanten Wert gehalten wird, bis hieraus in einem nachfolgenden Analog-Digital-Wandler ein digitales Datenwort gebildet werden kann.

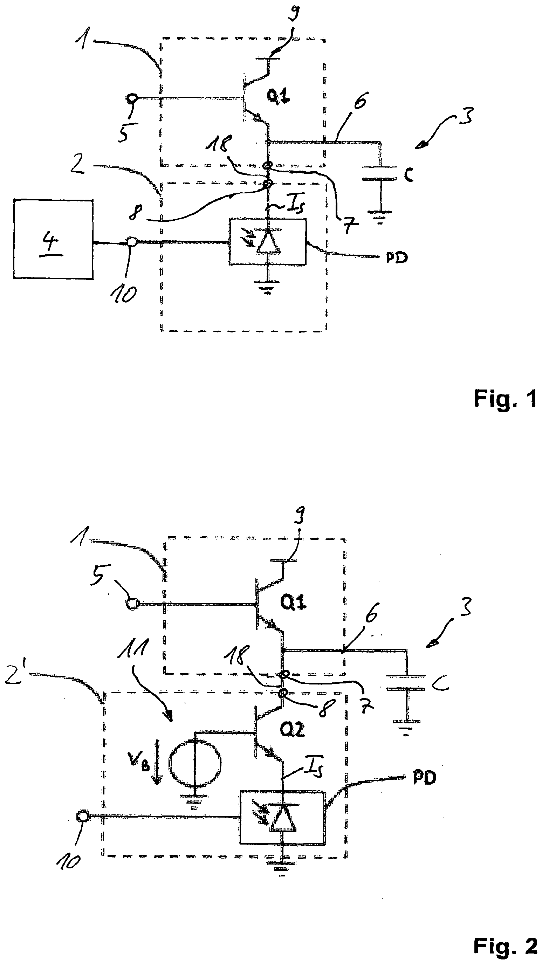

Nach einer ersten Ausführungsform der Erfindung gemäß der Figur 1 besteht die Folge-Halte-Schaltung aus einer Spannungsverstärkereinheit 1, einer Arbeitspunkteinstelleinheit 2, einer Haltekapazitätseinheit 3 und einer Taktsignalqueileneinheit 4.

Die Spannungsverstärkereinheit 1 weist einen Eingang 5 auf, an dem ein analoges Eingangsspannungssignal anlegbar ist. Ferner weist die Spannungsverstärkereinheit 1 einen Ausgang 6 auf, der mit einem Eingang der Haltekapazitätseinheit 3 verbunden ist. Darüber hinaus weist die Spannungsverstärkereinheit 1 einen Steuereingang 7 auf, der mit einem Steuerausgang 8 der Arbeitspunkteinstelleinheit 2 verbunden ist. An dem Steuereingang 7 liegt ein Steuersignal 18 der Arbeitspunkteinstelleinheit 2 an.

Die Spannungsverstärkereinheit 1 weist eine Emitterfolgeschaltung bzw. Emitterfolger Q1 auf, dessen Basisanschluss an dem Eingang 5, dessen Kollektoranschluss an einem Versorgungspotential 9 und dessen Emitteranschluss an dem Steuereingang 7 und am Ausgang 6 anliegt.

Die Haltekapazitätseinheit 3 weist eine Kapazität C auf, die an dem Ausgang 6 der Spannungsverstärkereinheit 1 anliegt.

Die Arbeitspunkteinstelleinheit 2 weist als elektrooptisches Mittel eine in Sperrrichtung betriebene Fotodiode PD auf, die an dem Steuereingang 7 der Spannungsverstärkereinheit 1 und an einem Masseanschluss anliegt. Die Fotodiode PD weist einen optischen Eingang 10 auf bzw. ist über eine optische Schnittstelle 10 mit der Taktsignalquelleneinheit 4 gekoppelt, die als optische Taktsignalquelle zur Erzeugung eines Taktsignals in Form einer optischen Impulsfolge mit einem hohen Taktsignal und einem tiefen Taktsignal ausgebildet ist. Beispielsweise kann die Taktsignalquelle als ein modengekoppelter Laser ausgebildet sein.

Liegt ein hohes optisches Taktsignal an, fließt durch die Fotodiode PD ein Strom lₛ. Erzeugt die Taktsignalquelle 4 ein optisches tiefes Taktsignal, fließt kein Strom lₛ durch die Fotodiode PD (I_{S} = 0). Als tiefes Taktsignal kann beispielsweise ein fehlendes optisches Signal sein, so dass nicht genügend Photonen bereitgestellt werden können für das Fließen eines Stromes durch die Fotodiode PD. Ein optisches hohes Taktsignal kann beispielsweise durch einen optischen Puls erzeugt werden, der eine bestimmte optische Mindestleistung aufweist.

Liegt an dem Eingang der Arbeitspunkteinstelleinheit 2 ein hohes optisches Taktsignal an, fließt ein Strom lₛ durch die Fotodiode PD. Der Emitterfolger Q1 wird eingeschaltet, so dass die Spannung am Eingang 6 der Haltekapazitätseinheit 3 der Eingangsspannung am Eingang 5 der Spannungsverstärkereinheit 1 folgt (Folgebetrieb). Liegt ein optisch tiefes Taktsignal an dem Eingang 10 der Arbeitspunkteinstelleinheit 2 an, ist der Emitterstrom des Emitterfolgers Q1 null und derselbige ausgeschaltet, so dass sich die Ausgangsspannung 6 bzw. die Eingangsspannung 6 der Haltekapazitätseinheit 3 nicht verändern kann. Sie wird auf den konstanten Wert gehalten (Haltebetrieb).

An der Fotodiode PD liegt eine Spannung in Sperrrichtung an. In Abhängigkeit von dem optischen Taktsignal fließt ein Emitterstrom durch den Emitterfolger Q1 oder nicht. Die Arbeitspunkteinstelleinheit 2 steuert somit die Spannungsverstärkereinheit 1 mittels eines Stromes lₛ.

Nach einer weiteren Ausführungsform der Erfindung gemäß Figur 2 ist eine Sperrspannungskonstantschaltung 11 in der Arbeitspunkteinstelleinheit 2 nach der Ausführungsform gemäß Figur 1 integriert, so dass eine erweiterte Arbeitspunkteinstelleinheit 2' gebildet ist. Die Sperrspannungskonstantschaltung 11 bewirkt, dass die Fotodiode PD im Folgebetrieb der Folge-Halte-Schaltung bei einer konstanten Sperrspannung betrieben werden kann. Hierzu weist die Sperrspannungskonstantschaltung 11 einen Transistor Q2 in Basisschaltung auf, an dessen Basisanschluss eine vorgegebene konstante Arbeitspunktspannungsquelie V_{B} angeschlossen ist, an dessen Emitter die Fotodiode angeschlossen ist und dessen Kollektor den Ausgang 8 der Arbeitspunkteinstelleinheit 2' bildet. Die Arbeitspunktspannungsquelle V_{B} bewirkt eine konstante Spannung am Basisanschluss des Transistors Q2, die unabhängig von der Spannung am Ausgang 8 der Arbeitspunkteinstelleinheit 2' ist. Die Arbeitspunktspannung V_{B} ist so gewählt, dass die Sperrspannung der Fotodiode PD relativ hoch ist. Auf diese Weise kann die Bandbreite der Fotodiode PD vergrößert werden. Eine genaue Abtastung ergibt sich dadurch, dass die Pulsform des Stromes an dem Steuereingang 7 der Spannungsverstärkereinheit 1 gleich und unabhängig von der Eingangsspannung 5 und der Spannung am Ausgang 8 der Arbeitspunkteinstelleinheit 2' ist.

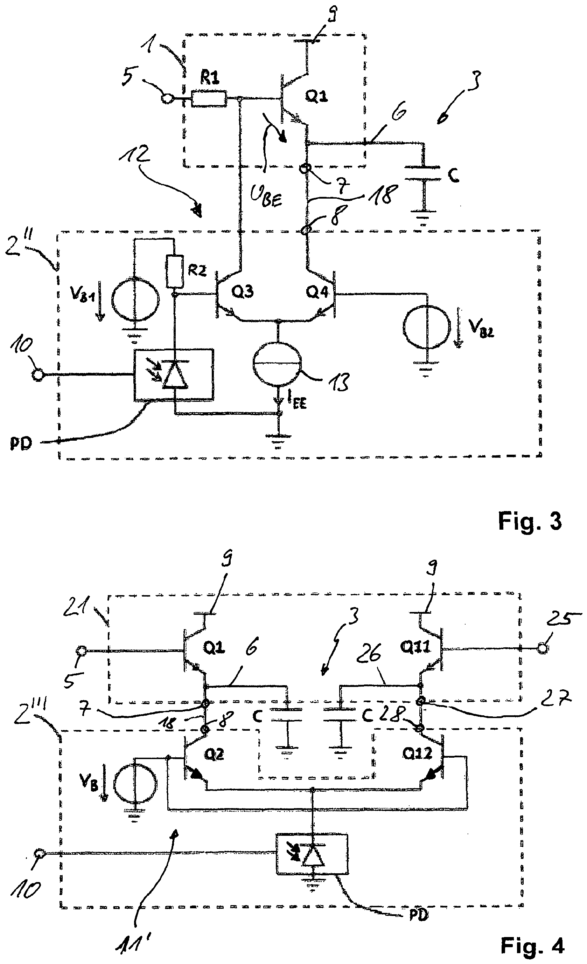

Nach einer weiteren Ausführungsform der Erfindung gemäß Figur 3 ist in einer alternativen Arbeitspunkteinstelleinheit 2" eine Basis-Emitter-Spannungsbegrenzungsschaltung (BE-Begrenzungsschaltung 12) vorgesehen, mittels derer die Basis-Emitterspannung U_{BE} des Emitterfolgers Q1 im Haltebetrieb begrenzt werden kann. Vorteilhaft lässt sich hierdurch die Spannung an dem Basisanschluss des Transistors Q1 reduzieren. Vorteilhaft kann hierdurch die Eingangsspannung 5 stärker variieren, ohne dass der Transistor Q1 eingeschaltet wird. Der Eingangsspannungsbereich am Eingang 5 der Spannungsverstärkereinheit 1 hat somit eine erhöhte Variationsbreite im Haltebetrieb.

Die BE-Begrenzungsschaltung 12 weist eine Stromquelle 13 auf, die über einen ersten Transistor Q3 direkt mit dem Basisanschluss des Transistors Q1 und über einen zweiten Transistor Q4 direkt mit dem Emitteranschluss des Transistors Q1 verbunden ist. Am Basisanschluss des zweiten Transistors Q4 liegt eine Vergleichsspannungsquelle V_{B2} an, die eine solche Höhe aufweist, dass wenn an der Arbeitspunkteinstelleinheit 2" ein tiefes Taktsignal anliegt und somit kein Strom durch die Fotodiode PD fließt, der erste Transistor Q3 leitet und der zweite Transistor Q4 sperrt. Die Spannung an der Basis des ersten Transistors Q3 ist in diesem Fall wesentlich höher als die Spannung an der Basis des zweiten Transistors Q4. Somit kann kein Strom zum Emitter des Transistors Q1 fließen, so dass dieser sperrt. Da der erste Transistor Q3 in Durchlassstellung ist, fließt ein Strom I_{EE} durch den ersten Transistor Q3 sowie durch einen Eingangswiderstand R1 der Spannungsverstärkereinheit 1, der zwischen dem Eingang 5 und der Basis des Transistors Q1 angeordnet ist. Zwischen dem Eingangswiderstand R1 und der Basis des Transistors Q1 ist der Kollektor des ersten Transistors Q3 angeschlossen. Durch den im Haltebetrieb fließenden Strom I_{EE} kann die Spannung an der Basis des Transistors Q1 begrenzt werden. Die Eingangsspannung am Eingang 5 der Spannungsverstärkungseinheit 1 kann somit stärker variieren, ohne dass der Transistor Q1 eingeschaltet wird.

Eine Arbeitspunkt-Spannungsquelle V_{B1} ist über einen Widerstand R2 an der Fotodiode PD und der Basis des ersten Transistors Q3 angeschlossen. Diese Arbeitspunkt-Spannung V_{B1} bewirkt - wie bei der Ausführungsform gemäß Figur 2 - eine konstante Sperrspannung der Fotodiode PD in dem Folgebetrieb der Folge-Halte-Schaltung.

Die Photodiode PD ist im Unterschied zu der Ausführungsform der Erfindung nach Figur 2 nicht emitterseitig an einem Transistor, sondern an einem Basisanschluss des ersten Transistors Q3 und über einen Widerstand R2 an der Arbeitspunkt-Spannungsquelle U_{B1} angeschlossen.

Im Folgebetrieb der Folge-Halte-Schaltung, also wenn am Eingang 10 der Arbeitspunkteinstellungsschaltung 2" ein hohes Taktsignal anliegt, leiten die Transistoren Q1 und Q4, während der Transistor Q3 sperrt, In der Fotodiode PD fließt ein Strom, der zu einem ausreichend hohen Spannungsabfall am Widerstand R2 führt. Die Spannung an der Basis des erster, Transistors Q3 ist somit wesentlich kleiner als die Spannung an der Basis des zweiten Transistors Q4. Der erste Transistor Q3 und der zweite Transistor Q4 dienen somit als Stromschalter, wobei entweder der erste Transistor Q3 oder der zweite Transistor Q4 durchgeschaltet ist. Im Folgebetrieb liegt aufgrund des gesperrten ersten Transistors Q3 und des leitenden zweiten Transistors Q4 eine relativ hohe Basis-Emitter-Spannung U_{BE} an, die ein sicheres Durchschalten des Transistors Q1 bewirkt.

Die BE-Begrenzungsschaltung 12 befindet sich mitdem Widerstand R2, den Transistoren Q3, Q4, der Stromquelle 13 sowie der Vergleichsspannung U_{B2} innerhalb der Arbeitspunkteinstelleinheit 2".

Nach einer weiteren Ausführungsform der Erfindung gemäß Figur 4 ist die Spannungsverstärkereinheit als eine Gegentaktspannungsverstärkereinheit 21 ausgebildet. Diese verfügt über zwei gleiche Emitterfolger Q1, Q11, deren Kollektoranschlüsse an das gleiche Versorgungspotenzial 9 angeschlossen sind. Die Gegentaktverstärkerschaltung 21 verfügt über zwei Gegentakteingänge 5, 25 sowie über zwei Gegentaktausgänge 6, 26, an denen jeweils Haltekapazitäten C der Haltekapazitätseinheit 3 angeschlossen sind. Die Arbeitspunkte der Emitterfolger Q1, Q11 werden im Gleichtakt über zwei Steuereingänge 7, 27 gesteuert, wobei der eine Steuereingang 7 der Arbeitspunkteinstelleinheit 2"' an dem Emitter des ersten Gegentakttransistors Q1 und der andere Steuereingang 27 der Arbeitspunkteinstelleinheit 2"' an dem Emitter des zweiten Gegentakttransistors Q11 angeschlossen ist. Die Transistoren Q1, Q2 sind in einem ersten Gegentaktzweig und die Transistoren Q11, Q12 sind in einem zweiten Gegentaktzweig angeordnet.

Die Arbeitspunkteinstelleinheit 2"' bzw. die Sperrspannungskonstantschaltung 11' weist im Unterschied zu der Ausführungsform gemäß Figur 2 nicht einen einzigen Arbeitspunkteinstelltransistor Q2, sondern zwei Arbeitspunkteinstelltransistoren Q2, Q12 in Basisschaltung auf, an deren Basis jeweils die Arbeitspunktspannung V_{B} angeschlossen ist und an deren Emitter jeweils dieselbe Fotodiode PD angeschlossen ist. Der Kollektoranschluss des einen Transistors Q2 dient als Steuereingang 7 für die Gegentaktverstärkereinheit 21 und der Kollektoranschluss des anderen Transistors Q2 als Steuereingang 27 der Gegentaktverstärkereinheit 21.

Im Haltebetrieb, wenn ein niedriges Taktsignal an der Fotodiode PD anliegt, sperren die Transistoren Q2, Q12 bzw. die Transistoren Q1, Q11, so dass die Ausgangsspannungen 6, 26 konstant bleiben. Liegt im Folgebetrieb ein hohes Taktsignal an der Fotodiode PD an, befinden sich die Transistoren Q2 und Q12 bzw. Q1 und Q1 1 in normal-aktiven Arbeitspunkten, so dass die Ausgangsspannungen 6, 26 jeweils den Eingangsspannungen 5, 25 folgen können. Vorteilhaft kann hierdurch die Folge-Halte-Schaltung in dem differenziellen Betrieb (Gegentaktbetrieb) arbeiten. Die Ausgangsspannungen 6, 26 sind nicht abhängig von der Versorgungsspannung 9 bzw. der Masse bzw. den Gleichtaktspannungsanteilen von 6, 26 bzw. den Gleichtaktspannungsanteilen von Eingangsspanngen 5, 25. Vorteilhaft ermöglicht diese Schaltung einen relativ kleinen Jitter des Abtasttaktes im Folgebetrieb, schnelle Schaltzeit, hohe Linearität der Abtastung, hohe Bandbreite, eine genaue Einstellung der Sperrspannung der Fotodiode PD unabhängig von den Eingangssignalen 5, 25 und eine hohe Gleichtaktsignalunterdrückung.

Nach einer weiteren Ausführungsform der Erfindung gemäß Figur 5 ist eine Folge-Halte-Schaltung mit einer Gegentaktspannungsverstärkereinheit 21' und einer Arbeitspunkteinstelleinheit 2^{IV} vorgesehen. Im Unterschied zu der Ausführungsform gemäß Figur 3 ist zusätzlich ein Gegentaktbetrieb integriert, so wie die Integration des Gegentaktbetriebes der Ausführungsform gemäß Figur 2 in der Ausführungsform gemäß Figur 4. Die Folge-Halte-Schaltung gemäß Figur 5 weist eine BE-Begrenzungsschaltung 22 auf, die im Wesentlichen der BE-Begrenzungsschaltung 12 gemäß Figur 3 entspricht, allerdings mit dem Unterschied, dass die Arbeitspunkt-Spannungsqueile V_{B1} nicht nur einem ersten Transistor Q3 des ersten Gegentaktzweiges, sondern auch einem ersten Transistor Q13 des zweiten Gegentaktzweiges zugeordnet ist, einerseits und dass die Vergleichsspannungsquelle V_{B2} nicht nur einem zweiten Transistor Q4 des ersten Gegentaktzweiges, sondern auch einem zweiten Transistor Q14 des zweiten Gegentaktzweiges zugeordnet ist, andererseits. Die BE-Begrenzungsschaltung 22 weist somit einen dem Transistor Q1 zugeordneten ersten Transistor Q3 und zweiten Transistor Q4 auf sowie einen dem weiteren Transistor Q11 zugeordneten ersten Transistor Q13 und zweiten Transistor Q14 auf. Emitterseitig sind die Transistorpaare Q3, Q4 bzw. Q13, Q14 jeweils an einer Stromquelle 13 angeschlossen. Die Arbeitsspannungsquelle V_{B1} und die Vergleichsspannungsquelle V_{B2} können jeweils für die Paare der Transistoren Q3, Q4 bzw. Q13, Q14 genutzt werden. Das gleiche gilt für den Strom der Fotodiode PD. Insofern ist der Aufwand zur Begrenzung der Basisemitterschaltung der Transistoren Q1, Q11 der Spannungsverstärkereinheit 21 relativ begrenzt. Die Schaltung verbindet die Vorteile der Schaltung nach Fig. 4 (Steuerung der Haltekapazitäten C im Gegentakt) mit dem zusätzlichen Vorteil der Ausführungsform gemäß Figur 3, dass der Eingangsspannungsbereich an den Eingängen 5, 25 der Spannungsverstärkereinheit 21 eine erhöhte Variationsbreite hat.

Gleiche Bauteile bzw. Bauteilfunktionen der Ausführungsbeispiele sind mit den gleichen Bezugsziffern versehen.

Es versteht sich, dass die erfindungsgemäßen Ausführungsformen nicht nur mit NPN-Bipolartransistoren, wie beschrieben, sondern auch mit PNP-Bipolartransistoren oder aber auch mit P-leitenden oder N-leitenden Feldeffekttransistoren oder anderen Transistortypen realisiert werden können.

## Patentansprüche

1. Folge-Halte-Schaltung zum Konvertieren eines analogen Eingangssignals in ein Ausgangs-Abtastsignal (7) mit einer Haltekapazitätseinheit (3), mit einer Spannungsverstärkereinheit (1, 21, 21') enthaltend einen Eingang (5, 25), an dem ein analoges Eingangsspannungssignal anlegbar ist, und enthaltend einen Ausgang (6, 26), der mit der Haltekapazitätseinheit (3) verbunden ist, mit einer Arbeitspunkteinstelleinheit (2) zur Erzeugung eines an einem Ausgang (8, 28) derselben anliegenden Steuersignals (18), das an einem Steuereingang (7, 27) der Spannungsverstärkereinheit (1, 21. 21') anliegt, wobei an einem Eingang (10) der Arbeitspunkteinstelleinheit (2) ein Taktsignal anliegt, dass in einem Folgebetrieb der Folge-Halte-Schaltung eine an dem Ausgang (6, 26) der Spannungsverstärkereinheit (1, 21, 21') anliegendes Ausgangssignal einen an den Eingang (5, 25) der Spannungsverstärkereinheit (1, 21, 21') anliegendes Eingangssignal folgt und in einem Haltebetrieb der Folge-Halte-Schaltung das Ausgangssignal (6,26) der Spannungsverstärkereinheit (1, 21, 21') konstant ist, mit einer Taktsignalquelle (4) zur Erzeugung einer Folge der der an dem Eingang (10) der Arbeitspunkteinstelleinheit (2, 2', 2", 2"',2^{IV}) anliegenden Taktsignale, dass die Arbeitspunkteinstelleinheit (2, 2', 2", 2"',2^{IV}) elektrooptische Mittel zur Erzeugung des Steuersignals (18) aufweist, dass die Taktsignalquelle (4) als eine optische Taktsignalquelle ausgebildet ist, dass als Taktsignal eine optische Impulsfolge mit hohen und tiefen Taktsignalen an den Eingang (10) der Arbeitspunkteinstelleinheit (2, 2', 2", 2"',2^{IV}) anliegt und dass mit dem Taktsignal die Arbeitspunkteinstelleinheit (2) so gesteuert wird, wobei sich die Spannungsverstärkereinheit (1,21, 21') entweder im Haltebetrieb oder im Folgebetrieb befindet, **dadurch gekennzeichnet,**
- **dass** die Arbeitspunkteinstelleinheit (2, 2', 2", 2"',2^{IV}) eine Sperrspannungskonstantschaltung (11,11') aufweist, mittels derer die Fotodiode (PD) im Folgebetrieb bei einer konstanten Sperrspannung betreibbar ist, und dass die Sperrspannungskonstantschaltung (11, 11') einen Transistor (Q2, Q12) in Basisschaltung aufweist, an dessen Basis eine vorgegebene konstante Arbeitspunktspannungsquelle (V_{B}) anliegt und dass die Fotodiode (PD) an einem Emitteranschluss des Transistors (Q2, Q12) angeschlossen ist und dass der Kollektor des Transistors (Q2, Q12) mit dem Ausgang (8, 28) der Arbeitspunkteinstelleinheit (2', 2"') verbunden ist, oder
- **dass** die Arbeitspunkteinstelleinheit (2", 2^{IV}) eine Basis-Emitter-Spannungsbegrenzungsschaltung (12, 22) zur Begrenzung der Basisemitterspannung (U_{BE}) des Emitterfolgers (Q1, Q11) der Spannungsverstärkereinheit (1, 21') im Haltebetrieb aufweist, wobei ein Strom (I_{EE}) von dem Eingang (5) der Spannungsverstärkereinheit (1, 21') über einen Eingangswiderstand (R1) von einem Basisanschluss des Emitterfolgers (Q1) parallel zu demselben abfließt.

2. Folge-Halte-Schaltung nach Anspruch 1, **dadurch gekennzeichnet, dass** die Spannungsverstärkereinheit (1, 21, 21') eine Emitterfolgeschaltung (Q1, Q11) aufweist.

3. Folge-Halte-Schaltung nach Anspruch 1 oder 2, **dadurch gekennzeichnet, dass** der Steuereingang (7, 27) der Spannungsverstärkereinheit (1, 21, 21') durch einen Ermitteranschluss der Ermitterfolgeschaltung (Q1, Q11) gebildet ist.

4. Folge-Halte-Schaltung nach einem der Ansprüche 1 bis 3, **dadurch gekennzeichnet, dass** die Arbeitspunkteinstelleinheit (2, 2', 2", 2"',2^{IV}) eine in Sperrrichtung betriebene Fotodiode (PD) aufweist, die bei Anliegen des hohen Taktsignals einen Strom (I_{S}) erzeugt für den Folgebetrieb und bei Anliegen des tiefen Taktsignals keinen Steuerstrom (I_{S}) erzeugt für den Haltebetrieb.

5. Folge-Halte-Schaltung nach Anspruch 1, **dadurch gekennzeichnet, dass** die Basis-Emitter-Spannungsbegrenzungsschaltung (12, 22) eine Stromquelle (13) und zwei mit derselben verbundenen Transistoren (Q3, Q4) aufweist, wobei ein erster Transistor (Q3, Q13) an seinem Kollektor direkt mit dem Basisanschluss des Transistors (Q1, Q11) der Spannungsverstärkereinheit (1, 21')und ein zweiter Transistor (Q4, Q14) an seinem Kollektor direkt mit einem Emitteranschluss des Transistors (Q1, Q11) der Spannungsverstärkereinheit (1, 21')verbunden ist, und dass eine konstante Vergleichsspannungsquelle (V_{B2}) an der Basis des zweiten Transistors (Q4, Q14) angeschlossen ist, und dass.eine Arbeitspunkt-Spannungsquelle (V_{B1}) über einen Widerstand (R2) mit der Basis des zweiten Transistors (Q3 Q13,) und mit der Fotodiode (PD) verbunden ist.

6. Folge-Halte-Schaltung nach einem der Ansprüche 1 bis 5, **dadurch gekennzeichnet, dass** die Spannungsverstärkereinheit als eine Gegentaktspannungsverstärkereinheit (21, 21') ausgebildet ist mit zwei gleichen, jeweils am gleichen Versorgungspotenzial (9) und in parallelen Gegentaktzweigen angeschlossene Emitterfolgeschaltungen (Q1, Q11), mit zwei Gegentakteingängen (5, 25) und mit zwei Gegentaktausgängen (7, 27), an denen jeweils eine Haltekapazität (C) angeschlossen sind, wobei die Haltekapazitäten (C) im Gegentakt gesteuert sind.

7. Folge-Halte-Schaltung nach Anspruch 6, **dadurch gekennzeichnet, dass** die Arbeitspunktsteuereinheit (2"') zwei Transistoren (Q2, Q12) in Basisschaltung aufweist, deren Basis mit derselben Arbeitspunktspannungsquelle (V_{B1}) und deren Emitter mit derselben Fotodiode (PD) verbunden sind.

8. Folge-Halte-Schaltung nach Anspruch 6, **dadurch gekennzeichnet, dass** der Gegentaktspannungsverstärkereinheit (21') eine Basis-Emitter-Spannungsbegrenzungsschaltung (22) zugeordnet ist, wobei der über seine Basis mit der Arbeitspunktspannungsquelle (V_{B1}) verbundene erste Transistor (Q3) des ersten Gegentaktzweiges an seinem Kollektor direkt mit dem Basisanschluss des Transistors (Q1) des ersten Gegentaktzweiges und der über seine Basis mit der Arbeitspunktspannungsquelle (V_{B1}) verbundene erste Transistor (Q13) des zweiten Gegentaktzweiges an seinem Kollektor direkt mit dem Basisanschluss des Transistors (Q11) des zweiten Gegentaktzweiges verbunden ist, und dass die konstante Vergleichsspannungsquelle (V_{B1}) über den Widerstand (R2) mit der Fotodiode (PD) verbunden ist, wobei das zweite Ende des Widerstands (R2) mit der Basis des ersten Transistors (Q3) des ersten Gegentaktzweiges und der Basis des ersten Transistors (Q13) des zweiten Gegentaktzweiges verbunden ist, und
- dass ein aus dem ersten Transistor (Q3) des ersten Gegentaktzweiges und einem zweiten Transistor (Q4) des ersten Gegentaktzweiges, der an seinem Kollektor direkt mit einem Emitteranschluss des Transistors (Q1) der Spannungsverstärkereinheit (21') verbunden ist, gebildetes erstes Transistorpaar und
- dass ein aus dem ersten Transistor (Q13) des zweiten Gegentaktzweiges und einem zweiten Transistor (Q14) des zweiten Gegentaktzweiges, der an seinem Kollektor direkt mit einem Emitteranschluss des weiteren Transistors (Q11) der Spannungsverstärkereinheit (21')verbunden ist ,gebildetes zweites Transistorpaar jeweils an ihren Emittern mit einer Stromquelle (13) verbunden sind, die einen Ausgangsstrom (I_{EE}) abgibt.

9. Analog-Digital-Wandler mit einer Folge-Halte-Schaltung nach einem der Ansprüche 1 bis 8.

## Claims

1. A sample and hold circuit for converting an analog input signal into an output sampling signal (7), comprising a hold-capacitor unit (3), comprising a voltage-amplifier unit (1, 21, 21') containing an input (5, 25), to which an analog input-voltage signal can be applied, and containing an output (6, 26), which is connected to the hold-capacitor unit (3), comprising an operating-point adjusting unit (2) for generating a control signal (18) applied to an output (8, 28) thereof, which signal is applied to a control input (7, 27) of the voltage-amplifier unit (1, 21, 21'), a clock signal being applied to an input (10) of the operating-point adjusting unit (2), in a sampling operation of the sample-and-hold circuit, an output signal applied to the output (6, 26) of the voltage-amplifier unit (1, 21, 21') following an input signal applied to the input (5, 25) of the voltage-amplifier unit (1, 21, 21') and, in a holding operation of the sample- and-hold circuit, the output signal (6, 26) of the voltage-amplifier unit (1, 21, 21') being constant, comprising a clock-signal source (4) for generating a sequence of the clock signals applied to the input (10) of the operating-point adjusting unit (2, 2', 2", 2"', 2^{IV}), the operating-point adjusting unit (2, 2', 2", 2"', 2^{IV}) comprising electro-optical means for generating the control signal (18), the clock-signal source (4) being configured as an optical clock-signal source, an optical pulse sequence having high and low clock signals being applied to the input (10) of the operating-point adjusting unit (2, 2', 2", 2"', 2^{IV}) in the form of a clock signal, and the operating-point adjusting unit (2) being controlled in this way by means of the clock signal, the voltage-amplifier unit (1, 21, 21') either being in holding operation or sampling operation, **characterized in that**
- the operating-point adjusting unit (2, 2', 2", 2"', 2^{IV}) comprises a reverse-voltage constant circuit (11, 11'), by means of which the photodiode (PD) can be operated in sampling operation at a constant reverse voltage, and **in that** the reverse-voltage constant circuit (11, 11') comprises a transistor (Q2, Q12) in a common base circuit, to the base of which a predetermined constant operating-point voltage source (V_{B}) is applied, and **in that** the photodiode (PD) is connected to an emitter terminal of the transistor (Q2, Q12) and **in that** the collector of the transistor (Q2, Q12) is connected to the output (8, 28) of the operating-point adjusting unit (2', 2"'), or
- **in that** the operating-point adjusting unit (2", 2^{IV}) comprises a base-emitter voltage-limiting circuit (12, 22) for limiting the base-emitter voltage (U_{BE}) of the emitter follower (Q1, Q11) of the voltage-amplifier unit (1, 21') in holding operation, a current (I_{EE}) flowing from the input (5) of the voltage-amplifier unit (1, 21') via an input resistor (R1) of a base terminal of the emitter follower (Q1) in parallel therewith.

2. The sample and hold circuit according to Claim 1, **characterized in that** the voltage-amplifier unit (1, 21, 21') comprises an emitter follower circuit (Q1, Q11).

3. The sample and hold circuit according to Claim 1 or 2, **characterized in that** the control input (7, 27) of the voltage-amplifier unit (1, 21, 21') is formed by an emitter terminal of the emitter follower circuit (Q1, Q11).

4. The sample and hold circuit according to any one of Claims 1 to 3, **characterized in that** the operating-point adjusting unit (2, 2', 2", 2"', 2^{IV}) comprises a photodiode (PD) that is operated in the reverse direction and generates a current (I_{S}) for sampling operation when the high clock signal is applied and does not generate a control current (I_{S}) for holding operation when the low clock signal is applied.

5. The sample and hold circuit according to Claim 1, **characterized in that** the base-emitter voltage-limiting circuit (12, 22) comprises a current source (13) and two transistors (Q3, Q4) connected thereto, a first transistor (Q3, Q13) being directly connected to the base terminal of the transistor (Q1, Q11) of the voltage-amplifier unit (1, 21') at its collector and a second transistor (Q4, Q14) being directly connected to an emitter terminal of the transistor (Q1, Q11) of the voltage-amplifier unit (1, 21') at its collector, and **in that** a constant reference-voltage source (V_{B2}) is connected to the base of the second transistor (Q4, Q14), and **in that** an operating-point voltage source (V_{B1}) is connected to the base of the second transistor (Q3, Q13) and to the photodiode (PD) via a resistor (R2).

6. The sample and hold circuit according to any one of Claims 1 to 5, **characterized in that** the voltage-amplifier unit is configured as a differential-mode-voltage amplifier unit (21, 21') comprising two identical emitter follower circuits (Q1, Q11) which are each connected to the same supply potential (9) and in parallel differential-mode branches and comprise two differential-mode inputs (5, 25) and two differential-mode outputs (7, 27), to each of which a hold capacitor (C) is connected, the hold capacitors (C) being controlled in differential mode.

7. The sample and hold circuit according to Claim 6, **characterized in that** the operating-point control unit (2') comprises two transistors (Q2, Q12) in a common base circuit, the base of which is connected to the same operating-point voltage source (V_{B1}) and the emitter of which is connected to the same photodiode (PD).

8. The sample and hold circuit according to Claim 6, **characterized in that** a base-emitter voltage-limiting circuit (22) is assigned to the differential-mode-voltage amplifier unit (21'), the first transistor (Q3) of the first differential-mode branch, which is connected to the operating-point voltage source (V_{B1}) via its base, is directly connected to the base terminal of the transistor (Q1) of the first differential-mode branch at its collector and the first transistor (Q13) of the second differential-mode branch, which is connected to the operating-point voltage source (V_{B1}) via its base, is directly connected to the base terminal of the transistor (Q11) of the second differential-mode branch at its collector, and **in that** the constant reference-voltage source (V_{B1}) is connected to the photodiode (PD) via the resistor (R2), the second end of the resistor (R2) being connected to the base of the first transistor (Q3) of the first differential-mode branch and the base of the first transistor (Q13) of the second differential-mode branch, and
- **in that** a first transistor pair formed by the first transistor (Q3) of the first differential-mode branch and a second transistor (Q4) of the first differential-mode branch, which is directly connected to an emitter terminal of the transistor (Q1) of the voltage-amplifier unit (21') at its collector and
- a second transistor pair formed by the first transistor (Q13) of the second differential-mode branch and a second transistor (Q14) of the second differential-mode branch, which is directly connected to an emitter terminal of the additional transistor (Q11) of the voltage-amplifier unit (21') at its collector, are each connected at their emitters to a current source (13) which outputs an output current (I_{EE}).

9. An analog-digital converter comprising a sample and hold circuit according to any one of Claims 1 to 8.

## Revendications

1. Circuit d'échantillonnage et de maintien destiné à convertir un signal d'entrée analogique en un signal échantillonné de sortie (7) avec une unité de maintien de capacité (3), avec une unité d'amplification de tension (1, 21, 21') comprenant une entrée (5, 25), à laquelle un signal de tension d'entrée analogique est applicable, et comprenant une sortie (6, 26), qui est reliée à l'unité de maintien de capacité (3), avec une unité de réglage de point de fonctionnement (2) destinée à générer un signal de commande (18) s'appliquant à une sortie (8, 28) de celle-ci même, qui est appliqué à une entrée de commande (7, 27) de l'unité d'amplification de tension (1, 21. 21'), dans lequel un signal d'horloge est appliqué à une entrée (10) de l'unité de réglage de point de fonctionnement (2), un signal de sortie appliqué à la sortie (6, 26) de l'unité d'amplification de tension (1, 21, 214`) suit un signal d'entrée appliqué à l'entrée (5, 25) de l'unité d'amplification de tension (1, 21, 21') dans un mode d'échantillonnage du circuit d'échantillonnage et de maintien et le signal de sortie (6,26) de l'unité d'amplification de tension (1, 21, 21') est constante dans un mode de maintien, avec une source de signaux d'horloge (4) destinée à générer une séquence des signaux d'horloge appliqués à l'entrée (10) de l'unité de réglage de point de fonctionnement (2, 2', 2", 2"`,2^{IV}), l'unité de réglage de point de fonctionnement (2, 2', 2", 2"',2^{IV}) présente des moyens électrooptiques destinés à générer le signal de commande (18), la source de signaux d'horloge (4) est conçue sous la forme d'une source optique de signaux d'horloge, qu'un train d'impulsions optiques avec des signaux d'horloge hauts et bas est appliqué à l'entrée (10) de l'unité de réglage de point de fonctionnement (2, 2', 2", 2"',2^{IV}) pour servir de signal d'horloge et que l'unité de réglage de point de fonctionnement (2) est ainsi commandée avec le signal d'horloge, dans lequel l'unité d'amplification de tension (1,21, 21') se trouve soit dans le mode de maintien soit dans le mode d'échantillonnage, **caractérisé en ce**
- **que** l'unité de réglage de point de fonctionnement (2, 2', 2", 2"',2^{IV}) présente un circuit de tension de blocage constante (11,11'), à l'aide duquel la photodiode (PD) est utilisable à une tension de blocage constante dans le mode d'échantillonnage, et que le circuit de tension de blocage constante (11, 11') présente un transistor (Q2, Q12) en circuit de base, à la base duquel une source de tension de polarisation constante (VB) est appliquée et que la photodiode (PD) est raccordée à une borne d'émetteur du transistor (Q2, Q12) et que le collecteur du transistor (Q2, Q12) est relié à la sortie (8, 28) de l'unité de réglage de point de fonctionnement (2', 2`"), ou
- **que** l'unité de réglage de point de fonctionnement (2", 2^{IV}) présente un circuit de limitation de tension base-émetteur (12, 22) destiné à limiter la tension base-émetteur (U_{BE}) de l'émetteur-suiveur (Q1, Q11) de l'unité d'amplification de tension (1, 21') dans le mode de maintien, dans lequel un courant (IEE) s'écoule de l'entrée (5) de l'unité d'amplification de tension (1, 21') en passant par une résistance d'entrée (R1) d'une borne de base de l'émetteur-suiveur (Q1) parallèlement à celui-ci même.

2. Circuit d'échantillonnage et de maintien selon la revendication 1, **caractérisé en ce que** l'unité d'amplification de tension (1, 21, 21') présente un circuit émetteur-suiveur (Q1, Q11).

3. Circuit d'échantillonnage et de maintien selon la revendication 1 ou 2, **caractérisé en ce que** l'entrée de commande (7, 27) de l'unité d'amplification de tension (1, 21, 21') est constituée par une borne d'émetteur du circuit émetteur-suiveur (Q1, Q11).

4. Circuit d'échantillonnage et de maintien selon l'une des revendications 1 à 3, **caractérisé en ce que** l'unité de réglage de point de fonctionnement (2, 2', 2", 2"',2^{IV}) une photodiode (PD) fonctionnant en polarisation inverse, qui génère un courant (Iₛ) pour le mode d'échantillonnage en cas d'application du signal d'horloge haut et qui ne génère aucun courant de commande (Iₛ) pour le mode de maintien en cas d'application du signal d'horloge bas.

5. Circuit d'échantillonnage et de maintien selon la revendication 1, **caractérisé en ce que** le circuit de limitation de tension base-émetteur (12, 22) présente une source de courant (13) et deux transistors (Q3, Q4) reliés à celle-ci même, dans lequel un premier transistor (Q3, Q13) est relié au niveau de son collecteur directement à la borne de base du transistor (Q1, Q11) de l'unité d'amplification de tension (1, 21') et qu'un second transistor (Q4, Q14) est relié au niveau de son collecteur directement à la borne d'émetteur du transistor (Q1, Q11) de l'unité d'amplification de tension (1, 21'), et qu'une source de tension de référence constante (VB2) est raccordée à la base du second transistor (Q4, Q14), et qu'une source de tension de polarisation (VB1) est reliée à la base du second transistor (Q3, Q13) et à la photodiode (PD) par le biais d'une résistance (R2).

6. Circuit d'échantillonnage et de maintien selon l'une des revendications 1 à 5, **caractérisé en ce que** l'unité d'amplification de tension est conçue sous la forme d'une unité d'amplification de tension en mode différentiel (21, 21') avec deux circuits émetteurs-suiveurs (Q1, Q11) identiques, raccordés respectivement au même potentiel d'alimentation (9) en branches symétriques parallèles, avec deux entrées symétriques (5, 25) et avec deux sorties symétriques (7, 27), auxquelles une capacité de maintien (C) est raccordée, dans lequel les capacités de maintien (C) sont commandées de manière symétrique.

7. Circuit d'échantillonnage et de maintien selon la revendication 6, **caractérisé en ce que** l'unité de réglage de point de fonctionnement (2"') présente deux transistors (Q2, Q12) en circuit de base, dont les bases sont reliées à la même source de tension de polarisation (VB1) et dont les émetteurs sont reliés à la même photodiode (PD).

8. Circuit d'échantillonnage et de maintien selon la revendication 6, **caractérisé en ce que** l'unité d'amplification de tension en mode différentiel (21') est associée à un circuit de limitation de tension base-émetteur (22), dans lequel le premier transistor (Q3) de la première branche symétrique, raccordé à la source de tension de polarisation (VB1) par sa base est relié au niveau de son collecteur directement à la borne de base du transistor (Q1) de la première branche symétrique et que le premier transistor (Q13) de la seconde branche symétrique, raccordé à la source de tension de polarisation (VB1) par sa base est relié au niveau de son collecteur directement à la borne de base du transistor (Q11) de la seconde branche symétrique, et que la source de tension de référence constante (VB1) est reliée à la photodiode (PD) par la résistance (R2), dans lequel la seconde extrémité de la résistance (R2) est reliée à la base du premier transistor (Q3) de la première branche symétrique et à la base du premier transistor (Q13) de la seconde branche symétrique, et
- qu'une première paire de transistors constituée du premier transistor (Q3) de la première branche symétrique et d'un second transistor (Q4) de la première branche symétrique, qui est relié au niveau de son collecteur directement à une borne d'émetteur du transistor (Q1) de l'unité d'amplification de tension (21') et
- qu'une seconde paire de transistors constituée du premier transistor (Q13) de la seconde branche symétrique et d'un second transistor (Q14) de la seconde branche symétrique, qui est relié au niveau de son collecteur directement à une borne d'émetteur de l'autre transistor (Q11) de l'unité d'amplification de tension (21') sont reliées respectivement au niveau de leurs émetteurs à une source de courant (13), qui fournit un courant de sortie (IEE).

9. Convertisseur analogique-numérique avec un circuit d'échantillonnage et de maintien selon l'une des revendications 1 à 8.
